# FASCICULE DE BREVET EUROPEEN

(11) **EP 4 034 896 B1**
(45) Date de publication et mention de la délivrance du brevet: **23.08.2023**
(21) Numéro de dépôt: 20785797.0
(22) Date de dépôt: 10.09.2020
(51) Int. Cl.: G01R 31/12, G01R 31/26, G01R 31/52

(54) **MODULE DE TEST DE COURANTS DE FUITE DANS UN CIRCUIT D'INHIBITION, SYSTÈME EMBARQUÉ LES COMPRENANT, ET VÉHICULE AUTOMOBILE L'INCORPORANT**
TESTMODUL FÜR LECKSTRÖME IN EINER INHIBITIONSSCHALTUNG, EINGEBETTETES SYSTEM, DAS DASSELBE UMFASST, UND DIESES ENTHALTENDES KRAFTFAHRZEUG
TEST MODULE FOR LEAKAGE CURRENTS IN AN INHIBITION CIRCUIT, EMBEDDED SYSTEM COMPRISING SAME, AND MOTOR VEHICLE INCORPORATING SAME

(30) Priorité: 26.09.2019 FR 1910663
(43) Date de publication de la demande: 03.08.2022
(73) Titulaire: PSA Automobiles SA, 78300 Poissy (FR)
(72) Inventeur: BERT, Jean-claude, 69420 CONDRIEU (FR); PERSEVAL, Herve, 91310 MONTLHERY (FR)
(86) Numéro de dépôt international: PCT/FR2020/051559
(87) Numéro de publication internationale: WO 2021/058890

(56) Documents cités:
- WO-A1-2018/110141
- CN-A- 108 761 284
- JP-A- 2007 095 848
- JP-A- 2007 173 493
- US-A1- 2004 070 899

## Description

### Domaine technique

La présente invention se rapporte de manière générale à la sécurité fonctionnelle et à la fiabilité des systèmes électriques et électroniques embarqués dans les véhicules automobiles, et notamment à la sécurité par interruption d'alimentation électrique de ces systèmes. Elle concerne plus particulièrement un module de test de courants de fuite dans un circuit d'inhibition (« muting » en anglais) pour véhicule automobile, ainsi qu'un système embarqué dans un véhicule automobile qui comprend un tel circuit et un tel module de test, et qu'un véhicule l'incorporant.

### Etat de la technique

La sécurité fonctionnelle et la fiabilité des systèmes dans les véhicules automobiles, et notamment les systèmes d'aide à la conduite (aussi appelés ADAS, de l'anglais « Advanced Driver Assistance Systems ») est un problème complexe. En cas d'accident, en effet, la responsabilité juridique du constructeur peut être directement engagée. Or, la présence de ces systèmes tend à se généraliser dans les véhicules automobiles modernes, ce qui fait de la problématique du respect des objectifs de leur sécurité fonctionnelle et de leur fiabilité de de fonctionnement un enjeu important.

La redondance fonctionnelle et la remontée d'informations de diagnostique sont des mesures qui aident à maintenir le système (et donc le véhicule) dans un état sûr (« Safe *state* » en anglais). Un état sûr est un mode de fonctionnement dans lequel le système (la chaîne de traction par exemple), et donc le véhicule, présentent un niveau de risque acceptable. Concernant la chaîne de traction d'un véhicule électrique ou hybride, par exemple, les états sûrs admissibles sont le fonctionnement nominal ou, en cas de défaillance, la mise du véhicule en roue libre (avec un voyant allumé au tableau de bord pour prévenir le conducteur) ou encore le maintien du véhicule à l'arrêt (interdiction de démarrer) s'il était déjà dans cette configuration. L'interdiction de démarrage (pas de commande de couple au niveau de l'onduleur) est applicable lors de la phase de démarrage du véhicule (initialisation des calculateurs et tests préliminaires avant d'autoriser la traction).

Dans ce contexte, différentes normes ont vu le jour dont, en 2011, la norme ISO 26262 concernant la sécurité fonctionnelle des systèmes électriques et électroniques automobiles, qui est applicable à l'électronique programmable des ADAS. L'application de la norme IS0 26262 pour les systèmes embarqués dans les véhicules automobiles, par exemple, entraîne un fort accroissement des niveaux d'intégrité de sécurité automobile, ou ASIL (de l'anglais « *Automotive Safety Integrity Level* ») qui sont exigés pour valider les équipements et les fonctions mises en oeuvre dans ces systèmes automobiles, dont notamment mais pas uniquement les ADAS. Cette norme impose de nouveaux protocoles d'évaluation de la sécurité des véhicules, qu'ils soient mis au point en Europe ou en Amérique du Nord. Ces équipements et ces fonctions sont cotés selon un niveau d'exigence en matière de sécurité, allant de ASIL A à ASIL D (D étant le niveau le plus critique), selon la Sévérité (S), l'Exposition (E) et la Contrôlabilité (C) de la situation dangereuse ou de l'évènement redouté (ER).

En particulier, les dispositifs de coupure (aussi appelés dispositifs d'inhibition) utilisés dans les véhicules pour couper l'alimentation par une batterie, notamment une batterie haute tension (de l'ordre de 400 Volts) fournissant l'énergie de traction à un groupe motopropulseur d'un véhicule électrique ou hybride, par exemple, devront bientôt satisfaire des exigences en matière de sécurité concernant des situations potentiellement à risque de type ASIL D. Ces exigences comprennent la faculté de couper l'alimentation électrique par une batterie en interrompant la circulation du courant dans les deux sens (depuis la batterie, et vers la batterie), afin d'isoler un équipement ou un accessoire considéré comme défectueux.

Une solution classique à base de relais présente pour inconvénients un nombre limité de commutations en raison de l'usure progressive des contacts, la nécessité d'une énergie relativement importante pour assurer les commutations, et en outre des problèmes de fiabilité du fait des pièces électromécaniques mises en oeuvre dans les relais.

C'est pourquoi, pour réaliser la fonction de coupure dans des applications automobiles, on peut utiliser un circuit d'inhibition à base de transistors, comme des transistors MOSFET (de l'anglais « *Metal Oxyde Semiconductor Field Effect Transistor* »)*.* Un tel circuit ne présente pas les inconvénients précités des relais. Par contre, les transistors MOSFET peuvent présenter des courants de fuite, qui affectent le pouvoir de coupure du circuit d'inhibition.

Un exemple d'élément de commutation auquel le module de détection de courants de fuite peut être appliqué, comprend un premier transistor MOSFET ainsi qu'un second transistor MOSFET montés en série, tête-bêche. Ces deux transistors MOSFET peuvent être commandés ensemble et simultanément par un contrôleur. Ainsi, l'élément de commutation peut assurer la coupure du courant dans les deux sens de circulation possibles à travers l'élément. L'invention propose un circuit de détection de l'existence éventuelle de courants de fuite dans un circuit d'inhibition du type précité, qui est capable de détecter un courant de fuite dans les deux sens de circulation du courant à travers l'élément de commutation, afin pour le circuit d'inhibition de pouvoir satisfaire une contrainte de coupure de type ASIL D.

Selon cette contrainte, le dispositif de commande du composant doit permettre de le rendre parfaitement non-passant, nonobstant l'existence éventuelle de courants de fuite dans les transistors MOSFET, quel que soit leur sens, afin de couper en sécurité l'alimentation électrique d'un système électrique ou électronique à fiabiliser. L'existence éventuelle de courants de fuite dans les transistors constitue un risque de dysfonctionnement du circuit d'inhibition, et c'est pourquoi il est souhaitable de la détecter, afin notamment de mettre en oeuvre la redondance de sécurité de fonctionnement, et éventuellement de remonter une information correspondante dans le cadre d'une opération de diagnostic.

Le document CN108761284 décrit un dispositif de test de fuite de courant au niveau du drain d'un MOSFET, mais n'apporte aucun enseignement utile pour la détection de courants de fuite dans un élément de commutation ayant deux transistors MOSFET montés tête-bêche pour couper le courant dans les deux sens de circulation possible du courant à travers ledit élément. On connait, par le document JP2007173493, un dispositif semi-conducteur comprenant un MOSFET de sortie, un transistor bipolaire couplé thermiquement avec le MOSFET de sortie, une résistance de détection de courant de fuite qui détecte le courant de fuite du transistor bipolaire et un circuit de coupure qui est connecté à la résistance de détection de courant de fuite.

### Résumé de l'invention

Plus spécifiquement, la solution retenue est un module de test avec deux sous-circuits de test de courant de fuite totalement indépendants l'un de l'autre, adaptés chacun pour détecter un éventuel courant de fuite entre le drain et la source de l'un respectif des deux transistors MOSFET montés en série et tête-bêche dans le circuit d'inhibition.

Dans un premier aspect, l'invention propose un circuit de détection de courant de fuite dans un circuit d'inhibition qui fonctionne par coupure d'alimentation électrique d'un système électrique ou électronique de véhicule automobile et qui comprend au moins un premier élément de commutation adapté pour pouvoir être placé dans un état passant ou dans un état non passant, ledit élément de commutation ayant une première borne et une seconde borne et ayant un premier transistor MOSFET et un second transistors MOSFET qui sont couplés chacun par leur drain à la première borne et à la seconde borne, respectivement, et qui sont montés en série et tête-bêche pour empêcher chacun le passage de courant dans l'un des deux sens de circulation possible du courant à travers l'élément de commutation lorsque ledit élément de commutation est dans l'état non-passant, ledit circuit de détection de courant de fuite comprenant :
- une première borne d'entrée et une seconde borne d'entrée destinées à être couplées à la première borne (100) et à la seconde borne, respectivement, de l'élément de commutation du circuit d'inhibition ;
- un premier sous-circuit couplé à la première borne d'entrée et à la seconde borne d'entrée, et adapté pour détecter un éventuel courant de fuite dans le premier transistor MOSFET de l'élément de commutation du circuit d'inhibition lorsque ledit élément de commutation est commandé pour être dans l'état non-passant ; et,
- un second sous-circuit couplé à la première borne d'entrée et à la seconde borne d'entrée, et adapté pour détecter un éventuel courant de fuite dans le second transistor MOSFET de l'élément de commutation du circuit d'inhibition lorsque ledit élément de commutation est commandé pour être dans l'état non-passant,
   dans lequel le premier sous-circuit et le second sous-circuit sont séparés et indépendants l'un de l'autre.

Par circuits séparés l'un de l'autre, on entend des circuits qui n'ont aucun élément constitutif en commun l'un avec l'autre. Par circuits indépendants l'un de l'autre, on entend des circuits tels que le fonctionnement de l'un des circuits ne fait pas intervenir l'autre circuit, et réciproquement. Cette indépendance des sous-circuits de détection de courants de fuite permet au circuit d'inhibition qui incorpore le circuit de détection de fuite les comprenant, de pouvoir respecter une contrainte de type ASIL D.

Dans un mode de réalisation le premier sous-circuit et le second sous-circuit peuvent comprendre, chacun :
- un comparateur de tension ayant une première entrée recevant une tension de seuil déterminée, une seconde entrée, et une sortie ;
- une source de tension isolée adaptée pour générer une tension de référence déterminée lorsqu'elle est activée par un signal de commande ; et,
- un pont diviseur de tension avec une première entrée couplée à la source de tension pour recevoir la tension de référence, avec une seconde entrée couplée à la seconde borne d'entrée ou à la première borne d'entrée, respectivement, du circuit de détection de courants de fuite, et avec une sortie couplée à la seconde entrée du comparateur ;
- une diode couplant la sortie du pont diviseur de tension à la première entrée ou à la seconde entrée, respectivement, du circuit de détection de courants de fuite, pour recopier sur ladite sortie la tension sur le drain du premier transistor MOSFET ou la tension sur le drain du second transistor MOSFET, respectivement, de l'élément de commutation du circuit d'inhibition,

et, en outre, la sortie du comparateur peut être adaptée pour délivrer au moins un signal de détection d'un éventuel courant de fuite dans le premier transistor MOSFET ou dans le second transistor MOSFET, respectivement, de l'élément de commutation du circuit d'inhibition, lorsque la source de tension isolée est
activée par le signal de commande alors que l'élément de commutation est commandé pour être dans l'état non-passant.

Dans un autre mode de réalisation, le premier sous-circuit et le second sous-circuit peuvent comprendre chacun au moins un optocoupleur agencé en sortie du comparateur pour délivrer le signal de détection.

Enfin, le pont diviseur de tension du premier sous-circuit et/ou le pont diviseur de tension du second sous-circuit peuvent comprendre, chacun, une première résistance connectée entre la première entrée et la sortie dudit pont diviseur de tension, ainsi qu'une seconde résistance connectée, à travers une diode, entre la sortie dudit pont diviseur de tension et la seconde borne d'entrée ou la première borne d'entrée, respectivement, du circuit de détection de courants de fuite.

Un deuxième aspect de l'invention se rapporte un circuit d'inhibition par coupure d'alimentation électrique d'un système électrique ou électronique de véhicule automobile alimenté électriquement par une source d'alimentation électrique, ledit circuit d'inhibition comprenant :
- une première borne destinée à être couplée à la source d'alimentation électrique et une seconde borne destinée à être couplée au système ;
- au moins un premier élément de commutation à transistors MOSFET agencé entre la première borne et la seconde borne du circuit et adapté pour pouvoir être placé dans un état passant ou dans un état non passant, ledit premier élément de commutation comprenant un premier transistor MOSFET et un second transistor MOSFET agencés en série, tête-bêche, entre la première borne et la seconde borne ;
- un premier contrôleur adapté pour commander l'état passant ou non passant du premier élément de commutation ; et,
- un module détecteur de courants de fuite agencé entre la première borne et la seconde borne, et comprenant un premier circuit de détection de courant de fuite selon le premier aspect ci-dessus, couplé par sa première borne d'entrée et par sa seconde borne d'entrée entre la première borne et la seconde borne du circuit d'inhibition en parallèle avec le premier élément de commutation, pour détecter un courant de fuite éventuel dans le premier transistor MOSFET et/ou dans le second transistor MOSFET dit premier élément de commutation du circuit d'inhibition lorsque ledit premier élément de commutation est commandé pour être dans l'état non-passant.

Dans un mode de réalisation, le circuit d'inhibition peut comprendre, en outre :
- un second élément de commutation à transistors MOSFET, le premier élément de commutation et ledit second élément de commutation étant agencés en série, tête-bêche, entre la première borne et la seconde borne, ledit second élément de commutation étant adapté pour pouvoir être placé dans un état passant ou dans un état non passant et comprenant un premier transistor MOSFET et un second transistor MOSFET agencés en série, tête-bêche, entre la première borne et la seconde borne ;
- un second contrôleur électriquement indépendant du premier contrôleur et adapté pour commander l'état passant ou non-passant du second élément de commutation,
et le module détecteur de courants de fuite peut alors comprendre un second circuit de détection de courant de fuite selon le premier aspect ci-dessus, couplé par sa première borne d'entrée et par sa seconde borne d'entrée entre la première borne et la seconde borne du circuit d'inhibition en parallèle avec le second élément de commutation, pour détecter un courant de fuite éventuel dans le premier transistor MOSFET et/ou dans le second transistor MOSFET du second élément de commutation du circuit d'inhibition lorsque ledit second élément de commutation est commandé pour être dans l'état non-passant.

Dans un autre mode de réalisation, le premier contrôleur et/ou le second contrôleur peuvent comprendre chacun une logique de commande et un circuit de commande de grille isolé agencé entre ladite logique de commande, d'une part, et les grilles de commande des premier et second transistors MOSFET du premier élément de commutation et du second élément de commutation, respectivement, d'autre part.

Dans un autre mode de réalisation :
- le premier sous-circuit du premier circuit de détection de courants de fuite du module détecteur de courants de fuite est adapté pour générer :
   un signal de détection d'un courant de fuite éventuel dans le premier transistor du premier élément de commutation, délivré au premier contrôleur ; et,
   un signal de détection d'un courant de fuite éventuel dans le premier transistor du premier élément de commutation, délivré au second contrôleur ;
- le second sous-circuit du premier circuit de détection de courants de fuite du module détecteur de courants de fuite est adapté pour générer :
   un signal de détection d'un courant de fuite éventuel dans le second transistor du premier élément de commutation, délivré au premier contrôleur ; et,
   un signal de détection d'un courant de fuite éventuel dans le second transistor du premier élément de commutation, délivré au second contrôleur ;
- le premier sous-circuit du second circuit de détection de courants de fuite du module détecteur de courants de fuite est adapté pour générer :
   un signal de détection d'un courant de fuite éventuel dans le premier transistor du second élément de commutation, délivré au premier contrôleur ; et,
   un signal de détection d'un courant de fuite éventuel dans le second transistor du second élément de commutation, délivré au second contrôleur ; et, enfin,
- le second sous-circuit du second circuit de détection de courants de fuite du module détecteur de courants de fuite est adapté pour générer :
   un signal de détection d'un courant de fuite éventuel dans le second transistor du second élément de commutation, délivré au premier contrôleur ; et,
   le signal de détection d'un courant de fuite éventuel dans le second transistor du second élément de commutation, délivré au second contrôleur.

Un troisième aspect de l'invention se rapporte à un système embarqué dans un véhicule automobile qui comprend un circuit d'inhibition du type précité, avec un module de test de courants de fuite selon le deuxième aspect ci-dessus, qui est adapté pour tester la présence éventuelle de courants de fuite dans le circuit d'inhibition, dans les deux sens de circulation possible du courant à travers ledit circuit.

Un quatrième et dernier aspect de l'invention se rapporte à un véhicule automobile comprenant un système embarqué selon le troisième aspect ci-dessus.

### Brève description des figures

D'autres caractéristiques et avantages de l'invention apparaîtront encore à la lecture de la description qui va suivre. Celle-ci est purement illustrative et doit être lue en regard des dessins annexés sur lesquels :
**[****Fig. 1****]** la figure 1 est un diagramme fonctionnel d'un circuit d'inhibition auquel peut être appliqué le module de test de courant de fuite selon des modes de réalisation ;
**[****Fig. 2****]** la figure 2 est un diagramme fonctionnel d'un mode de réalisation d'un module de test de courant de fuite adapté pour être appliqué au circuit d'inhibition de la Figure 1 ;
**[****Fig. 3****]** la figure 3 est un diagramme détaillé d'un premier sous-circuit du module de test de courant de fuite de la figure 2 ; et,
**[****Fig. 4****]** la figure 4 est un diagramme détaillé d'un second sous-circuit du module de test de courant de fuite de la figure 2.

### Description des modes de réalisation

Dans la description de modes de réalisation qui va suivre et dans les Figures des dessins annexés, les mêmes éléments ou des éléments similaires portent les mêmes références numériques aux dessins.

Dans la suite du présent exposé, on entend par « défaillance » d'un système, la cessation de l'aptitude du système à accomplir une fonction requise ou à fonctionner comme prévu.

On entend par « défaillance de cause commune » (ou « défaillance en mode commun ») une défaillance résultant d'un ou plusieurs événements qui, provoquant des défaillances simultanées de deux ou plusieurs éléments séparés dans un système multiéléments, conduit à la défaillance du système. On entend par fonction « d'inhibition » (ou « *muting* » en anglais), l'interruption temporaire d'une ou des fonctions relatives à la sécurité, par des parties de systèmes de commande relatives à la sécurité. Cette interruption peut être souhaitable afin de protéger le système, ou d'autres systèmes dans le véhicule, ou plus généralement dans un objectif de sécurité de fonctionnement ou de sécurité des passagers.

Enfin, on entend par « redondance », l'existence de plusieurs moyens pour accomplir une fonction requise dont l'un peut intervenir, avec la même efficacité, en substitution de l'autre en cas de défaillance de ce dernier.

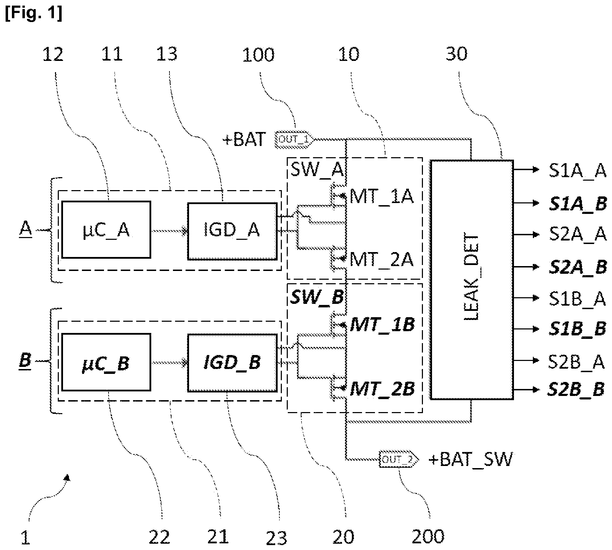

En référence au schéma de la **figure 1**, un exemple de circuit d'inhibition 1 auquel peut être appliqué un module de test de courant de fuite selon des modes de réalisation de l'invention, comprend une première borne 100 et une seconde borne 200. La borne 100 est destinée à être couplée à une source d'alimentation électrique, par exemple une batterie du véhicule (non représentée) qui délivre une tension d'alimentation +VBAT. La borne 200 est destinée à être couplée à un système électrique ou électronique du véhicule automobile (non représenté), qui est alimenté par la batterie précitée pour son fonctionnement. Par exemple, un tel système peut être un ADAS. Dans un autre exemple, il peut s'agir d'un dispositif de maintien de la tension du réseau (DMTR), dans un véhicule automobile équipé d'un système d'arrêt et de relance automatique du moteur thermique, dit « Stop & Start.

Du point de vue fonctionnel, le circuit d'inhibition 1 agit comme un interrupteur adapté pour commuter, sur la borne 200, la tension de la batterie +VBAT qui est disponible sur la borne 100. Dit autrement, la borne 200 est adaptée pour délivrer une version commutée +VBAT_SW de la tension d'alimentation +VBAT disponible sur le noeud 100, en fonction de l'état ouvert ou fermé du circuit 1. Dit autrement, encore, le circuit 1 est adapté pour inhiber le fonctionnement du système couplé à la borne 200 par la coupure de son alimentation électrique fournie par la source d'alimentation couplée à la borne 100.

L'homme du métier appréciera que du courant peut s'écouler de la borne 100 vers la borne 200, mais également dans l'autre sens, à savoir de la borne 200 vers la borne 100, en fonction des applications, que cette circulation de courant dans les deux sens possibles soit volontaire ou non. Un exemple de circulation volontaire de courant dans les deux sens possibles est celui d'un système électrique comme un alterno-démarreur, adapté pour être alimenté par la batterie dans une certaine phase de fonctionnement (en mode démarreur), et pour recharger la batterie en générant un courant de recharge de la batterie dans une autre phase de fonctionnement (en mode alternateur). Un exemple de circulation involontaire de courant dans les deux sens possibles est par exemple le cas où la borne 200 peut être couplée à une autre batterie, de valeur nominale supérieure à celle de la batterie couplée à la borne 100, avec une défaillance des moyens normalement prévus pour prévenir la mise en court-circuit des deux batteries en empêchant le couplage simultané des deux batteries à la borne 200.

Du point de vue structurel, le circuit d'inhibition 1 tel que montré à la figure 1 comprend un premier élément de commutation 10 à transistors MOSFET et un second élément de commutation 20 à transistors MOSFET. Ces deux éléments de commutation 10 et 20 sont agencés en série, tête-bêche, entre la première borne 100 et la seconde borne du circuit 200. Ils sont adaptés pour pouvoir être placé, chacun, dans un état passant ou dans un état non passant. En opération, les circuits de commutation 10 et 20 sont redondants l'un de l'autre, dans la mesure où si l'un ou l'autre seulement de ces circuits est non passant, la fonction de coupure du circuit 1 est assurée. Ainsi, par exemple, si l'élément de commutation 10 était défaillant, en sorte que par exemple il existerait à l'état non passant un courant de fuite entre son drain et sa source, il serait possible d'empêcher que ce courant de fuite (et tout autre courant) ne circule entre les bornes 100 et 200, en commandant l'état non passant de l'élément de commutation 20 redondant (ceci en supposant que celui-ci, bien entendu, ne soit pas lui-même défaillant).

De manière plus générale, le circuit d'inhibition 1 comprend deux voies, notées A et B à la figure 1, qui peuvent chacune assurer la fonction de coupure du circuit de manière redondante l'une de l'autre, et qui comprennent à cet effet, respectivement, l'élément de commutation 10 et l'élément de commutation 20. Avantageusement, ces deux voies A et B sont indépendantes, et ce aussi bien du point de vue de la constitution des éléments de commutation 10 et 20 que du point de vue des contrôleurs 11 et 21, qui en assurent la commande, respectivement, comme il apparaîtra de la description qui sera donnée plus loin desdits contrôleurs 11 et 21.

On notera que, à la figure 1, les indications désignant des éléments constitutifs et des signaux se rapportant à la voie B sont présentées en caractères gras et italiques, pour les distinguer des éléments et signaux correspondants qui se rapportent à la voie A.

Dans un exemple de circuit d'inhibition auquel des modes de réalisation du module de test de l'invention peut être appliqué, l'élément de commutation 10 et l'élément de commutation 20 comprennent chacun un premier transistor MOSFET, noté MT_A1 et MT_B1, respectivement, à la figure 1, ainsi qu'un second transistor MOSFET, noté MT_A2 et MT_B2, respectivement, à la figure 1. Dans chacun des éléments de commutation 10 et 20, ces premier et second transistors MT_A1 et MT_A2, ou MT_B1 et MT_B2, respectivement, sont montés en série, tête-bêche. Au sein de chacune des voies A et B, ces deux transistors MOSFET montés tête-bêche des éléments de commutation 10 et 20, respectivement, sont commandés ensemble et simultanément par le contrôleur 11 et par le contrôleur 21, respectivement. A cet effet, les grilles de commande des deux transistors MT_1A et MT_2A sont connectées ensemble à une sortie de commande du contrôleur 11, et leurs sources sont connectées ensemble à une autre sortie de commande dudit contrôleur 11. De la même façon, les grilles de commande des deux transistors MT_1B et MT_2B sont connectées ensemble à une sortie de commande du contrôleur 12, et leurs sources sont connectées ensemble à une autre sortie de commande dudit contrôleur 12. Ainsi, chacun des éléments de commutation 10 et 20 peut assurer la coupure du courant dans les deux sens de circulation possibles entre les bornes 100 et 200, à savoir de la borne 100 vers la borne 200, ou réciproquement, et ce indépendamment l'un de l'autre.

Par exemple, les transistors MOSFET du premier élément de commutation 10 et/ou les transistors MOSFET du second élément de commutation 20 sont des transistors MOS de type N. De tels transistors sont mieux adaptés aux applications de puissance que les transistors MOS de type P ou les transistors IBGT (de l'anglais « *Isolated Gate Bipolar Transistor* »), car ils peuvent passer des courants relativement plus importants.

Ainsi qu'il a été mentionné plus haut, les deux voies A et B du circuit 1 redondées sont contrôlées indépendamment l'une de l'autre. A cet effet, les contrôleurs 11 et 21 précités sont entièrement séparés, et indépendants l'un de l'autre dans leur constitution et dans leur fonctionnement.

Plus particulièrement, le contrôleur 11 de la voie de A et/ou le contrôleur 21 de la voie de commande B peuvent comprendre chacun une logique de commande 12 et 22, respectivement, ainsi qu'un circuit de commande de grille isolé 13 et 23, respectivement. Chacun des circuits de commande de grille isolé 13 et 23 est agencé entre, d'une part, la logique de commande 12 ou 22, respectivement, et, d'autre part, la grille de commande des premier et second transistors MT_1A et MT_2A ou MT_1B et MT_2B, respectivement, du premier élément de commutation 10 et du second élément de commutation 20, respectivement.

Grâce à la redondance procurée en soi par la voie A et la voie B et notamment l'indépendance des contrôleurs 11 et 21, le circuit d'inhibition 1 peut respecter une exigence de niveau ASIL D très contraignante.

On va maintenant décrire les moyens fonctionnels qui permettent de mettre en oeuvre la redondance opérationnelle entre les deux voies A et B, ou plutôt, plus particulièrement, entre les deux éléments de commutation 10 et 20.

Le circuit 1 comprend en effet un module 30 qui opère comme détecteur de courants de fuite, agencé entre la borne 100 et la borne 200, en parallèle avec l'ensemble formé par les éléments de commutation 10 et 20 en série entre lesdites bornes. Ce détecteur de courants de fuite 30 est adapté pour détecter l'existence éventuelle d'un courant de fuite dans les transistors MOSFET du premier élément de commutation 10 et/ou du second élément de commutation 20, lorsque ledit élément est commandé par son contrôleur associé 11 ou 21, respectivement, pour être à l'état non passant. Un tel courant de fuite traduit un dysfonctionnement de l'élément de commutation considéré, dont il résulte que la fonction de coupure associée au circuit 1 n'est plus assurée, ou bien n'est plus qu'imparfaitement assurée. Typiquement, un tel courant de fuite peut être causé par l'endommagement voire le claquage de la capacité drainsource d'un des transistors MOSFET).

C'est pourquoi le cas échéant, c'est-à-dire en cas de détection d'un tel courant de fuite dans l'élément de commutation 10 ou 20, le détecteur de courants de fuite 30 notifie une information correspondante au contrôleur 21 ou au contrôleur 11, respectivement, qui est chargé de contrôler l'état passant ou non passant de l'autre élément de commutation 20 ou 10, respectivement, afin que cet autre élément de commutation soit commandé à la place ou en complément de l'élément de commutation considéré comme défectueux du fait de ces courants de fuite. Comme l'homme du métier l'aura compris, ceci est réalisé à des fins de redondance fonctionnelle entre l'élément de commutation 10 et l'élément de commutation 20 relativement à la mise à l'état non passant de ces éléments, laquelle vise à couper l'alimentation électrique du système qui est couplé à la borne 200.

Plus particulièrement, dans l'exemple montré à la figure 1, le détecteur de courants de fuite 30 est adapté pour générer huit signaux, qui sont délivrés aux contrôleurs 11 ou 21, à savoir :
- le signal S1A_A qui donne une information relative à un dysfonctionnement éventuel (i.e., l'existence de courants de fuite entre son drain et sa source) du premier transistor MT_1A de la voie A, délivré au contrôleur 11 de ladite voie A ;
- le signal S1A_B qui donne une information relative à un dysfonctionnement éventuel du premier transistor MT_1A de la voie A, délivré au contrôleur 21 de l'autre voie, à savoir la voie B ;
- le signal S2A_A qui donne une information relative à un dysfonctionnement éventuel du second transistor MT_2A de la voie A, délivré au contrôleur 11 de ladite voie A ;
- le signal S2A_B qui donne une information relative à un dysfonctionnement éventuel du second transistor MT_2A de la voie A, délivré au contrôleur 21 de la voie B ;
- le signal S1B_A qui donne une information relative à un dysfonctionnement éventuel du premier transistor MT_1B de la voie B, délivré au contrôleur 11 de l'autre voie, à savoir la voie A ;
- le signal S1B_B qui donne une information relative à un dysfonctionnement éventuel du second transistor MT_1B de la voie B, délivré au contrôleur 21 de ladite voie B ;
- le signal S2B_A qui donne une information relative à un dysfonctionnement éventuel du second transistor MT_2B de la voie B, délivré au contrôleur 11 de la voie A ; et, enfin,
- le signal S2B_B qui donne une information relative à un dysfonctionnement éventuel du second transistor MT_2B de la voie B, délivré au contrôleur 21 de ladite voie B.

Plus particulièrement, les signaux précités sont délivrés à la logique de commande 12 ou 22 du contrôleur 11 ou 21, respectivement de la voie A ou B, respectivement. Ainsi, les voies A et B sont adaptées pour se commander l'une l'autre, mais indépendamment l'une de l'autre, via les signaux ci-dessus, générés par le détecteur de courants de fuite 30.

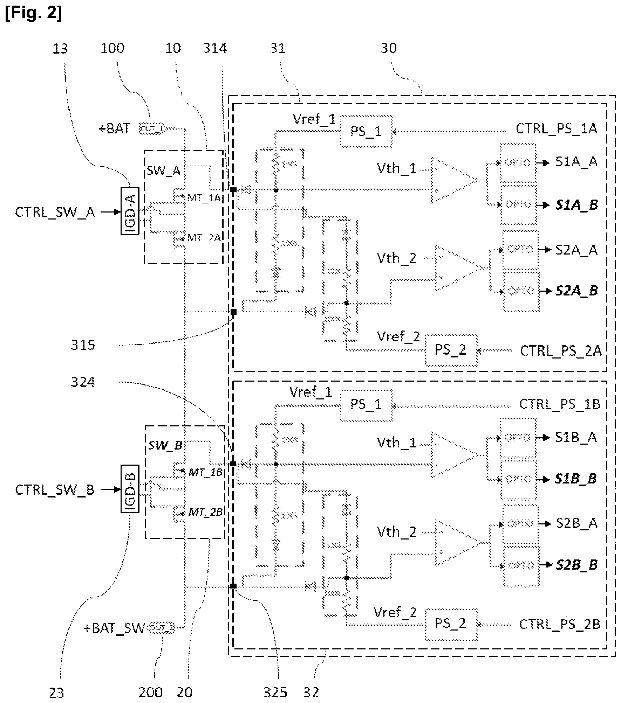

La description détaillée de l'architecture et du fonctionnement du module détecteur de courants de fuite 30 va maintenant être donnée en référence aux schémas des figures 2, 3 et 4.

La **figure 2** ne montre, en partie gauche, que les circuits de commande de grille isolé 13 et 23 qui attaquent les premier et second transistors MT_1A et MT_2A ou MT_1B et MT_2B, respectivement, du premier élément de commutation 10 et du second élément de commutation 20, respectivement. Ces circuits 13 et 23 sont commandés, comme montré à la figure, par des signaux de commande CRTL_SW_A et CTRL_SW_B, respectivement. Ces signaux sont générés par la logique de commande 12 et par la logique de commande 22, respectivement, de la figure 1.

En partie droite, la figure 2 montre que le module détecteur de courants de fuite 30 comprend un premier circuit de détection de courants de fuite 31 (aussi appelé « circuit de test » dans ce qui suit, par raccourci) pour le test de l'existence éventuelle de courants de fuite dans l'élément de commutation 10, ainsi qu'un second circuit de détection de courants de fuite 32 (également appelé « circuit de test » dans ce qui suit) pour le test de l'existence éventuelle de courants de fuite dans l'élément de commutation 20.

Le circuit 31 comprend deux bornes d'entrée 314 et 315 par lesquelles il peut être couplé en parallèle avec l'élément de commutation 10. Plus particulièrement, la borne 314 est couplée au drain du transistor MT_1A (ou transistor « *high-side* » de l'élément de commutation 10), alors que la borne 315 est couplée au drain du transistor MT_2A (ou transistor « *low-side* » de l'élément de commutation 10). De même, le circuit 32 comprend deux bornes d'entrée 324 et 325 par lesquelles il peut être couplé en parallèle avec l'élément de commutation 20. Plus particulièrement, la borne 324 est adaptée pour être couplée au drain du transistor MT_1B (ou transistor « *high-side* » de l'élément de commutation 20), alors que la borne 325 est adaptée pour être couplée au drain du transistor MT_2B (ou transistor « *low-side* » de l'élément de commutation 20).

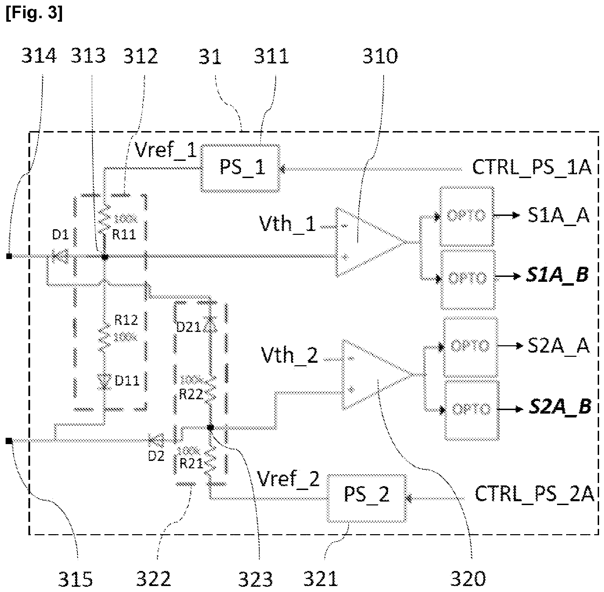

Comme montré à la figure 3, le circuit de test 31 comprend un premier sous-circuit de test, lequel comprend un comparateur 310, une source de tension isolée 311, un pont diviseur de tension 312 ainsi qu'une diode D1.

La source de tension isolée 311 est adaptée pour délivrer une tension de référence Vref_1, par exemple de 5 Volts (V) ou de 3.3 V, lorsqu'elle est activée par un signal de commande CTRL_PS_1A. Dans un exemple, ce signal est actif à l'état logique haut (i.e., à la valeur logique 1). La tension de référence Vref_1 est délivrée sur une première entrée du pont diviseur de tension 312, dont la seconde entrée est couplée à la borne 315 à travers une diode de protection D11.

La diode D11 a pour fonction d'empêcher une fuite de courant depuis le circuit d'inhibition 1 vers le circuit de test 31. A cet effet, la diode D11 est connectée par sa cathode à la borne 315, et par son anode à la seconde entrée du pont diviseur de tension 312.

Le noeud de sortie 313 du pont diviseur de tension 312 est couplé à une première entrée du comparateur 310, par exemple l'entrée non-inverseuse de ce comparateur. L'autre entrée du comparateur 310, à savoir son entrée inverseuse dans l'exemple, reçoit une tension de seuil Vth_1, qui sert de base à la comparaison. Dit autrement, lorsque la tension sur le noeud de sortie 313 du pont diviseur de tension 312 est inférieure à la tension seuil Vth_1, la sortie du comparateur 310 est dans un premier état logique, par exemple à l'état logique haut (ou 1 logique). Inversement, lorsque la tension sur le noeud de sortie 313 du pont diviseur de tension 312 est supérieure à la tension seuil Vth_1, la sortie du comparateur 310 est dans un second état logique, à savoir à l'état logique bas (ou 0 logique) dans l'exemple. Lorsque les résistances R11 et R12 formant le pont diviseur de tension 312 sont de même valeur, par exemple égale à 100 kiloohms dans l'exemple représenté, la tension seuil Vth_1 est fixée à sensiblement la moitié de la valeur de la tension de référence Vref_1, soit environ 2.5 V dans l'exemple.

La sortie du comparateur 310 génère le signal de détection S1A_A à travers un premier optocoupleur, et le signal de détection S1A_B (qui est identique au signal S1A_A d'un point de vue logique) à travers un second optocoupleur. Cette dualité des signaux S1A_A et S1A_B contribue à l'indépendance des voies A et B du circuit d'inhibition redondé, relativement l'une à l'autre. En outre, les optocoupleurs assurent l'isolation du circuit de test 31 par rapport aux éléments du système auquel les signaux S1A_A et S1A_B sont transmis. Tout ceci permet le respect de la contrainte de type ASIL D par le circuit d'inhibition 1 avec son module de détection de courants de fuite qui comprend le circuit de test 31 considéré ici.

Le premier sous-circuit du circuit de test 31 comprend en outre la diode de protection D1 par laquelle le noeud de sortie 313 du pont diviseur de tension 312 est couplé à la borne 314. Dit autrement, le noeud de sortie 313 du pont diviseur de tension 312 est couplé à la borne 314 à travers la diode D1 pour recevoir la tension de drain du transistor « *high-side* » de l'élément de commutation sous test (à la chute de tension aux bornes de la diode près, laquelle peut être d'environ 0.2 V, selon la technologie de fabrication de la diode D1). La diode D1 a pour fonction d'empêcher une fuite de courant depuis le circuit d'inhibition 1 vers le circuit de test 31. A cet effet, la diode D1 est connectée par sa cathode à la borne 314, et par son anode à la sortie 313 du pont diviseur de tension 312.

En outre, et comme également montré à la **figure 3****,** le circuit de test 31 comprend aussi un second sous-circuit de test, lequel comprend un autre comparateur 320, une autre source de tension isolée 321, un autre pont diviseur de tension 322, et une autre diode D2.

La source de tension isolée 321 est adaptée pour délivrer une tension de référence Vref_2, par exemple de 5 V ou de 3.3 V, lorsqu'elle est activée par un signal de commande CTRL_PS_2A. Dans un exemple, ce signal est actif à l'état logique haut (i.e., à la valeur logique 1). La tension de référence Vref_2 est délivrée sur une première entrée du pont diviseur de tension 322, dont la seconde entrée est couplée à la borne 314 à travers une diode de protection D21.

La diode D21 a pour fonction d'empêcher une fuite de courant depuis le circuit d'inhibition 1 vers le circuit de test 31. A cet effet, la diode D21 est connectée par sa cathode à la borne 314, et par son anode à la seconde entrée du pont diviseur de tension 322.

Le noeud de sortie 323 du pont diviseur de tension 322 est couplé à une première entrée du comparateur 320, par exemple l'entrée non-inverseuse de ce comparateur. L'autre entrée du comparateur 320, à savoir son entrée inverseuse dans l'exemple, reçoit une tension de seuil Vth_2, qui sert de base à la comparaison. Dit autrement, lorsque la tension sur le noeud de sortie 323 du pont diviseur de tension 322 est inférieure à la tension seuil Vth_2, la sortie du comparateur 320 est dans un premier état logique, par exemple à l'état logique haut (ou 1 logique). Inversement, lorsque la tension sur le noeud de sortie 323 du pont diviseur de tension 322 est supérieure à la tension seuil Vth_2, la sortie du comparateur 320 est dans un second état logique, à savoir à l'état logique bas (ou 0 logique) dans l'exemple. Lorsque les résistances R21 et R22 formant le pont diviseur de tension 322 sont de même valeur, par exemple égale à 100 kiloohms dans l'exemple représenté, la tension seuil Vth_2 est fixée à sensiblement la moitié de la valeur de la tension de référence Vref_2, soit environ 2.5 V dans l'exemple.

La sortie du comparateur 320 génère le signal de détection S2A_A à travers un premier optocoupleur, et le signal de détection S2A_B (qui est identique au signal S2A_A d'un point de vue logique) à travers un second optocoupleur. Cette dualité des signaux S2A_A et S2A_B contribue à l'indépendance des voies A et B du circuit d'inhibition redondé, relativement l'une à l'autre. En outre, les optocoupleurs assurent l'isolation du circuit de test 31 par rapport aux éléments du système auquel les signaux S2A_A et S2A_B sont transmis. Tout ceci permet le respect de la contrainte de type ASIL D par le circuit d'inhibition 1 avec son module de détection de courants de fuite qui comprend le circuit de test 31 considéré ici.

Le second sous circuit du circuit de test 31 comprend en outre une diode de protection D2 par laquelle le noeud de sortie 323 du pont diviseur de tension 322 est couplé à la borne 315. Dit autrement, le noeud de sortie 323 du pont diviseur de tension 322 est couplé à la borne 315 à travers la diode D2 pour recevoir la tension de drain du transistor « *high-side* » de l'élément de commutation sous test (à la chute de tension aux bornes de la diode D2 près, laquelle peut être d'environ 0.2 V, selon la technologie de fabrication de la diode D2). La diode D2 a pour fonction d'empêcher une fuite de courant depuis le circuit d'inhibition 1 vers le circuit de test 31. A cet effet, la diode D2 est connectée par sa cathode à la borne 314, et par son anode à la sortie 313 du pont diviseur de tension 312.

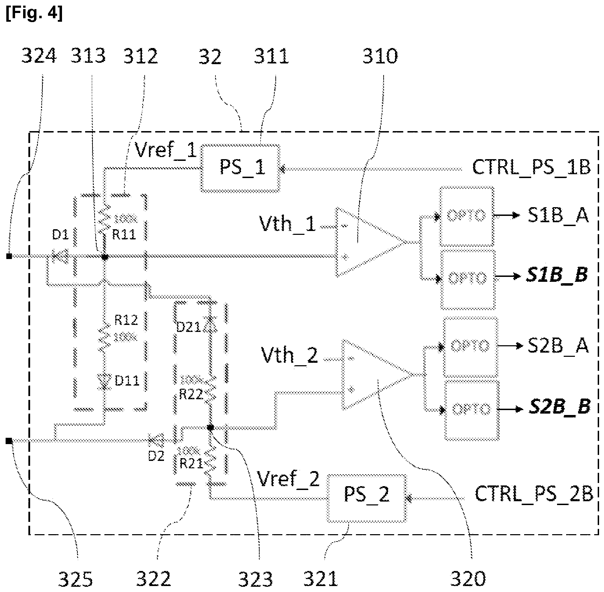

Comme montré à la **figure 4**, le circuit de test 32 est identique, du point de vue de sa conception, au circuit de test 31. C'est pourquoi la figure 4 ne sera pas décrite en détail ici.

On rappellera simplement que le circuit 32 est commandé par les signaux CTRL_PS-1B et CTRL_PS_2B, au lieu des signaux CTRL_PS-1A et CTRL_PS_2B, respectivement, qui commandent le circuit de test 31 de la figure 3.

En outre la sortie du comparateur 310 du circuit de test 32 de la figure 4 génère le signal de détection S1B_A à travers un premier optocoupleur, et le signal de détection S1B_B (qui est identique au signal S1B_A d'un point de vue logique) à travers un second optocoupleur, au lieu des signaux S1A_A et S1A_B, respectivement, qui sont générés par le comparateur 310 du circuit de test 31 de la figure 3.

De même, la sortie du comparateur 320 du circuit de test 32 de la figure 4 génère le signal de détection S2B_A à travers un premier optocoupleur, et le signal de détection S2B_B (qui est identique au signal S2B_A d'un point de vue logique) à travers un second optocoupleur, au lieu des signaux S2A_A et S2A_B, respectivement, qui sont générés par le comparateur 320 du circuit de test 31 de la figure 3.

Le fonctionnement d'un circuit de détection de courant fuite tel que le circuit 31 et le circuit 32 du module de détection de courants fuite 30 décrits ci-dessus, va maintenant être exposé, toujours en référence aux schémas des figures.

Ce fonctionnement est piloté, aux fins du test de l'existence éventuelle de courants de fuite dans l'un et/ou l'autre des éléments de commutation 10 et 20, sous la commande d'une unité de commande ad-hoc. Il peut s'agir du calculateur du Boîtier de Servitude Intelligent (BSI) du véhicule (aussi appelé calculateur d'habitacle), ou de tout autre calculateur embraqué dans le véhicule. Le pilotage du test comprend la commande des signaux CTRL_PS_1A et CTRL_PS_2A du circuit de test 31 pour le test de l'élément de commutation 10, ainsi que la commande des signaux CTRL_PS_1B et CTRL_PS_2B du circuit de test 32 pour le test de l'élément de commutation 20. Il comprend aussi la commande des contrôleurs 11 et 21, afin de piloter l'état passant ou non passant des éléments de commutation 10 et 20 via les signaux CTRL_SW_A et CTRL_SW_B, respectivement.

Le test de fuite de l'élément de commutation 10, qui est réalisé avec le circuit 31, est indépendant du test de fuite de l'élément de commutation 20, lequel est réalisé avec le circuit 32. Ces deux tests sont réalisés, dans des phases de test distinctes, par exemple l'un après l'autre.

Pendant la phase de test de l'un des éléments de commutation 10 ou 20, l'autre élément de commutation 20 ou 10, respectivement, est commandé pour être mis dans l'état passant.

Ensuite au niveau de l'élément de commutation sous test, on commande (commande commune) les deux transistors MOSFET (à savoir les transistors MT_1A et MT_2A pour le test de l'élément de commutation 10, et les transistors MT_1B et MT_2B pour le test de l'élément de commutation 20) afin que ces deux transistors et donc l'élément de commutation sous test (10 ou 20, respectivement) soient dans l'état non-passant. Dans l'exemple, le signal de commande correspondant (à savoir CTRL_SW_A ou CTRL_SW_B, respectivement) est mis à l'état logique bas (i.e., à 0).

Ensuite, on active successivement (mais pas en même temps) la source de tension de référence 311 (dans une première sous-phase de test) puis la source de tension de référence 320 (dans une seconde sous-phase de test) du sous-circuit de test concerné (à savoir le sous-circuit 31 ou le sous-circuit 32, respectivement).

Pour la première sous-phase de test ci-dessus, ceci est réalisé, dans l'exemple, en faisant passer le signal de commande de ladite source de tension de référence 311 (à savoir le signal CTRL_PS_1A pour le test de l'élément de commutation 10 ou le signal CTRL_PS_1B pour le test de l'élément de commutation 20) à l'état logique haut (i.e. à 1) alors que le signal de commande de l'autre source de tension de référence 321 (à savoir le signal CTRL_PS_2A pour le test de l'élément de commutation 10 ou le signal CTRL_PS_2B pour le test de l'élément de commutation 20) est maintenu à l'état logique bas (i.e. à 0).

Pour la seconde sous-phase de test ci-dessus, ceci est réalisé, dans l'exemple, en faisant passer le signal de commande de l'autre source de tension de référence 321 (à savoir le signal CTRL_PS_2A pour le test de l'élément de commutation 10 ou le signal CTRL_PS_2B pour le test de l'élément de commutation 20) à l'état logique haut (i.e. à 1) alors que le signal de commande de la première source de tension de référence 311 (à savoir le signal CTRL_PS_1A pour le test de l'élément de commutation 10 ou le signal CTRL_PS_1B pour le test de l'élément de commutation 20) est maintenu à l'état logique bas (i.e. à 0).

Lors de la première des sous-phases ci-dessus, lorsque la source de tension 311 est activée, on détecte l'existence d'un courant de fuite au niveau du transistor « *high-side* » (à savoir le transistor MT_1A pour le test de l'élément de commutation 10, et le transistors MT_1B pour le test de l'élément de commutation 20, respectivement), grâce au comparateur 310 du sous-circuit de test concerné (31 ou 32, respectivement). Les signaux délivrés en sortie de ce comparateur 310 (à savoir les signaux S1A_A et S1A_B pour le test de l'élément de commutation 10, et les signaux S1B_A et S1B_B pour le test de l'élément de commutation 20, respectivement) sont par exemple à l'état logique bas (i.e., à 0) en l'absence de courant de fuite, alors qu'ils sont à l'état logique haut (i.e., à 1) en cas d'existence d'un courant de fuite dans le transistor « *high-side* » concerné (MT_1A ou MT_1B, respectivement). En effet, s'il existe un courant de fuite dans ce transistor, cela fait chuter la tension au niveau du noeud de sortie 313 du pont diviseur 312 en dessous de la tension de seuil Vth_1, et la sortie du comparateur 310 bascule de l'état logique base (i.e., de 0) à l'état logique haut (i.e., à 1).

Lors de la seconde des sous-phases ci-dessus, lorsque la source de tension 321 est activée, on détecte l'existence d'un courant de fuite au niveau du transistor « *low-side* » (à savoir le transistor MT_2A pour le test de l'élément de commutation 10, et le transistors MT_2B pour le test de l'élément de commutation 20), grâce au comparateur 320 du sous-circuit de test (31 ou 32, respectivement). Les signaux délivrés en sortie de ce comparateur 320 (à savoir les signaux S2A_A et S2A_B pour le test de l'élément de commutation 10, et les signaux S2B_A et S2B_B pour le test de l'élément de commutation 20) sont par exemple à l'état logique bas (i.e., à 0) en l'absence de courant de fuite, alors qu'ils sont à l'état logique haut (i.e. à 1) en cas d'existence d'un courant de fuite dans le transistor « *low-side* » concerné (MT_2A ou MT_2B, respectivement). En effet, s'il existe un courant de fuite dans ce transistor, cela fait chuter la tension au niveau du noeud de sortie 323 du pont diviseur 322 en dessous de la tension de seuil Vth_2, et la sortie du comparateur 320 bascule de l'état logique bas (i.e., de 0) à l'état logique haut (i.e., à 1).

On rappelle que les signaux de test délivrés en sortie par chacun des sous-circuits de test 31 et 32 sont fournis en entrée de la logique de commande de l'élément de commutation concerné par le test et en entrée de la logique de commande de l'autre élément de commutation afin de permettre la mise en oeuvre de la redondance de l'un par l'autre de ces éléments de commutation, le cas échéant, c'est-à-dire en cas de défaillance due à l'existence d'un courant de fuite dans l'un de ses transistors MOSFET. Avantageusement, ces signaux peuvent aussi être remontés à une unité de commande de plus haut niveau, à des fins par exemple de diagnostic. La défaillance peut alors être signalée, à l'utilisateur et/ou lors d'un diagnostic effectué en atelier, afin de permettre un remplacement de l'élément de commutation défectueux.

L'homme du métier appréciera que le test de l'existence de courants de fuite dans les éléments de commutation 10 et 20 est réalisé avec des tensions différentielles, appliquées à chaque fois à l'élément de commutation, 10 ou 20, concerné par le test. Ainsi il n'est pas nécessaire de s'occuper de ce qui se passe au niveau de l'autre élément de commutation, 20 ou 10, respectivement. En d'autres termes, la défaillance éventuelle de cet autre élément de commutation n'a pas d'incidence sur la détection de courants de fuite dans l'élément de commutation sous test.

En outre, dans chacun des circuits de test 31 et 32 les sous-circuits de test 310-311-312 et 320-321-322 respectivement dédié à la détection d'un courant de fuite dans chacun des sens de circulation du courant, sont indépendants et sont redondés l'un par l'autre. La mise en oeuvre de cette redondance peut être basée sur une logique combinatoire appliquées aux signaux de test délivrés par le module détecteur de courants de fuite 30. L'information est portée, de manière redondante, par chacun des quartets de signaux de détection formés par les quatre signaux indiqués en caractère normaux à la droite de la figure 2, d'une part, et par les quatre signaux indiqués en caractères gras et italiques à la droite de la figure 2, d'autre part. Cette redondance desdits sous-circuits de test au sein de chacun des circuits de test 31 et 32 fait que son second sous-circuit de test permet de garantir la sécurité de fonctionnement de l'ensemble dudit circuit de test 31 ou 32 si son premier sous-circuit de test est défaillant, et réciproquement. Ainsi, le module détecteur de courants de fuite 30 respecte aussi, lui-même, un niveau de sécurité

### ASIL D.

La présente invention a été décrite et illustrée dans la présente description détaillée et dans les figures des dessins annexés, dans des formes de réalisation possibles. La présente invention ne se limite pas, toutefois, aux formes de réalisation présentées. D'autres variantes et modes de réalisation peuvent être déduits et mis en oeuvre par la personne du métier à la lecture de la présente description et des dessins annexés.

En particulier, dans le contexte de l'exemple de mise en oeuvre qui a été décrit dans ce qui précède, le circuit de détection de courants de fuite est mis en oeuvre en double, à savoir une mise en oeuvre dans le circuit 31 pour le test de l'élément de commutation 10 de la voie A, et une autre mise en oeuvre dans le circuit 32 pour le test de l'élément de commutation 20 de la voie B, ces deux éléments de commutation 10 et 20 étant redondants l'un de l'autre. Cette mise en oeuvre en double permet de garantir une complète indépendance des voies A et B, jusque dans les moyens de détection de courants de fuite dans leurs éléments de commutation respectifs. Mais l'invention ne se limite pas à cet exemple. En particulier, l'invention peut s'appliquer à un circuit d'inhibition qui ne comprend qu'un unique élément de commutation comme les éléments 10 et 20 (ou au contraire plus de deux tels éléments de commutation) agencé(s) entre les bornes 100 et 200 du circuit d'inhibition 1 de la figure 1. En effet, l'homme du métier apprécie que le ou les éléments de commutation sont tous agencés entre ces bornes, le cas échéant en série. Un circuit respectif de détection de courants de fuite comme les circuits 31 et 32 permet de détecter un éventuel courant de fuite dans chacun des deux transistors MOSFET, pour chacun de ces éléments de commutation. Chaque circuit de détection de courants de fuite est alors couplé en parallèle avec l'élément de commutation concerné.

Dans le présent exposé, le terme "comprendre" ou "comporter" n'exclut pas d'autres éléments ou d'autres étapes. Un seul processeur ou plusieurs autres unités peuvent être utilisées pour mettre en oeuvre l'invention. Les différentes caractéristiques présentées peuvent être avantageusement combinées. Leur présence dans des parties différentes, n'excluent pas cette possibilité. Les signes de référence ne sauraient être compris comme limitant la portée de l'invention.

## Revendications

1. Circuit (31) destiné à détecter un courant de fuite dans un circuit d'inhibition (1) qui fonctionne par coupure d'alimentation électrique d'un système électrique ou électronique de véhicule automobile et qui comprend au moins un premier élément de commutation (10) adapté pour pouvoir être placé dans un état passant ou dans un état non passant, ledit élément de commutation ayant une première borne (100) et une seconde borne (200) et ayant un premier transistor MOSFET (MT_1A) et un second transistors MOSFET (MT_12) qui sont couplés chacun par leur drain à la première borne et à la seconde borne, respectivement, et qui sont montés en série et tête-bêche pour empêcher chacun le passage de courant dans l'un des deux sens de circulation possible du courant à travers l'élément de commutation lorsque ledit élément de commutation est dans l'état non-passant, ledit circuit de détection de courant de fuite étant **caractérisé en ce qu'**il comprend :
- une première borne d'entrée (314) et une seconde borne d'entrée (315) destinées à être couplées à la première borne (100) et à la seconde borne (200), respectivement, de l'élément de commutation (10) du circuit d'inhibition (1) ;
- un premier sous-circuit (310,311,312,D1) couplé à la première borne d'entrée et à la seconde borne d'entrée, et adapté pour détecter un éventuel courant de fuite dans le premier transistor MOSFET (MT_1A) de l'élément de commutation (10) du circuit d'inhibition (1) lorsque ledit élément de commutation est commandé pour être dans l'état non-passant ; et,
- un second sous-circuit (320,321,322,D2) couplé à la première borne d'entrée et à la seconde borne d'entrée, et adapté pour détecter un éventuel courant de fuite dans le second transistor MOSFET (MT_2A) de l'élément de commutation (10) du circuit d'inhibition (1) lorsque ledit élément de commutation est commandé pour être dans l'état non-passant,
dans lequel le premier sous-circuit et le second sous-circuit sont séparés et indépendants l'un de l'autre.

2. Circuit de détection de courant de fuite selon la revendication 1, dans lequel le premier sous-circuit (310,311,312,D1) et le second sous-circuit (320,321,322,D2) comprennent, chacun :
- un comparateur de tension (310,320) ayant une première entrée recevant une tension de seuil déterminée (Vth_1,Vth_2), une seconde entrée, et une sortie ;
- une source de tension isolée (311,321) adaptée pour générer une tension de référence déterminée (Vref_1,Vref_2) lorsqu'elle est activée par un signal de commande (CRTL_PS_1A,CTRL_PS_2A) ; et,
- un pont diviseur de tension (312,322) avec une première entrée couplée à la source de tension pour recevoir la tension de référence, avec une seconde entrée couplée à la seconde borne d'entrée (315,325) ou à la première borne d'entrée (314,324), respectivement, du circuit de détection de courants de fuite (31), et avec une sortie (313,323) couplée à la seconde entrée du comparateur ;
- une diode (D1,D2) couplant la sortie (313,323) du pont diviseur de tension à la première entrée (314,324) ou à la seconde entrée (315,325), respectivement, du circuit de détection de courants de fuite (31), pour recopier sur ladite sortie la tension sur le drain du premier transistor MOSFET (MT_1A) ou la tension sur le drain du second transistor MOSFET (MT_2A), respectivement, de l'élément de commutation (10) du circuit d'inhibition (1), dans lequel la sortie du comparateur est adaptée pour délivrer au moins un signal de détection (S1A_A,S2A_A) d'un éventuel courant de fuite dans le premier transistor MOSFET (MT_1A) ou dans le second transistor MOSFET (MT_2A), respectivement, de l'élément de commutation (10) du circuit d'inhibition (1), lorsque la source de tension isolée (311,321) est activée par le signal de commande (CRTL_PS_1A,CTRL_PS_2A) alors que l'élément de commutation (10) est commandé pour être dans l'état non-passant.

3. Circuit de détection de courant de fuite selon la revendication 2, dans lequel le premier sous-circuit et le second sous-circuit comprennent chacun au moins un optocoupleur agencé en sortie du comparateur (310,320) pour délivrer le signal de détection (S1A_A,S2A_A).

4. Circuit de détection de courant de fuite selon l'un quelconque des revendications 2 et 3, dans lequel le pont diviseur de tension (312) du premier sous-circuit et/ou le pont diviseur de tension (322) du second sous-circuit comprennent, chacun, une première résistance (R11) connectée entre la première entrée et la sortie (313,323) dudit pont diviseur de tension, ainsi qu'une seconde résistance (R12) connectée, à travers une diode (D11,D12), entre la sortie (313,323) dudit pont diviseur de tension et la seconde borne d'entrée (315,325) ou la première borne d'entrée (314,324), respectivement, du circuit de détection de courants de fuite (31).

5. Circuit (1) d'inhibition par coupure d'alimentation électrique d'un système électrique ou électronique de véhicule automobile alimenté électriquement par une source d'alimentation électrique, ledit circuit d'inhibition comprenant :
- une première borne (100) destinée à être couplée à la source d'alimentation électrique et une seconde borne (200) destinée à être couplée au système ;
- au moins un premier élément de commutation (10) à transistors MOSFET agencé entre la première borne et la seconde borne du circuit et adapté pour pouvoir être placé dans un état passant ou dans un état non passant, ledit premier élément de commutation comprenant un premier transistor MOSFET (MT_A1) et un second transistor MOSFET (MT_A2) agencés en série, tête-bêche, entre la première borne (100) et la seconde borne (200) ;
- un premier contrôleur (11) adapté pour commander l'état passant ou non passant du premier élément de commutation ; et,
- un module (30) détecteur de courants de fuite agencé entre la première borne (100) et la seconde borne (200), et comprenant un premier circuit de détection de courant de fuite (31) selon l'une quelconque des revendications 1 à 4, couplé par sa première borne d'entrée (314) et par sa seconde borne d'entrée (315) entre la première borne (100) et la seconde borne (200) du circuit d'inhibition (1) en parallèle avec le premier élément de commutation (10), pour détecter un courant de fuite éventuel dans le premier transistor MOSFET (MT_1A) et/ou dans le second transistor MOSFET (MT _2A) dit premier élément de commutation (10) du circuit d'inhibition (1) lorsque ledit premier élément de commutation (10) est commandé pour être dans l'état non-passant.

6. Circuit d'inhibition selon la revendication 5, comprenant en outre :
- un second élément de commutation (20) à transistors MOSFET, le premier élément de commutation (10) et ledit second élément de commutation (20) étant agencés en série, tête-bêche, entre la première borne et la seconde borne, ledit second élément de commutation étant adapté pour pouvoir être placé dans un état passant ou dans un état non passant et comprenant un premier transistor MOSFET (MT_1B) et un second transistor MOSFET (MT_2B) agencés en série, tête-bêche, entre la première borne (100) et la seconde borne (200) ;
- un second contrôleur (21) électriquement indépendant du premier contrôleur (11) et adapté pour commander l'état passant ou non-passant du second élément de commutation (20),
dans lequel le module (30) détecteur de courants de fuite comprend un second circuit de détection de courant de fuite (32) selon l'une quelconque des revendications 1 à 4, couplé par sa première borne d'entrée (324) et par sa seconde borne d'entrée (325) entre la première borne (100) et la seconde borne (200) du circuit d'inhibition (1) en parallèle avec le second élément de commutation (20), pour détecter un courant de fuite éventuel dans le premier transistor MOSFET (MT_1B) et/ou dans le second transistor MOSFET (MT_2B) du second élément de commutation (20) du circuit d'inhibition (1) lorsque ledit second élément de commutation (10) est commandé pour être dans l'état non-passant.

7. Circuit d'inhibition selon la revendication 5 ou la revendication 6, dans lequel le premier contrôleur (11) et/ou le second contrôleur (21) comprennent chacun une logique de commande (12,22) et un circuit de commande de grille isolé (13,23) agencé entre ladite logique de commande, d'une part, et les grilles de commande des premier et second transistors MOSFET du premier élément de commutation et du second élément de commutation, respectivement, d'autre part.

8. Circuit d'inhibition selon l'une quelconque des revendications 6 et 7, dans lequel :
- le premier sous-circuit (310,311,312,D1) du premier circuit de détection de courants de fuite (31) du module détecteur de courants de fuite (30) est adapté pour générer :
un signal (S1A_A) de détection d'un courant de fuite éventuel dans le premier transistor (MT_1A) du premier élément de commutation (10), délivré au premier contrôleur (11) ; et,
un signal (S1A_B) de détection d'un courant de fuite éventuel dans le premier transistor (MT_1A) du premier élément de commutation (10), délivré au second contrôleur (21) ;
- le second sous-circuit (320,321,322,D2) du premier circuit de détection de courants de fuite (31) du module détecteur de courants de fuite (30) est adapté pour générer :
un signal (S2A_A) de détection d'un courant de fuite éventuel dans le second transistor (MT_2A) du premier élément de commutation (10), délivré au premier contrôleur (11) ; et,
un signal (S2A_A) de détection d'un courant de fuite éventuel dans le second transistor (MT_2A) du premier élément de commutation (10), délivré au second contrôleur (21) ;
- le premier sous-circuit (310,311,312,D1) du second circuit de détection de courants de fuite (32) du module détecteur de courants de fuite (30) est adapté pour générer :
un signal (S1B_A) de détection d'un courant de fuite éventuel dans le premier transistor (MT_1B) du second élément de commutation (20), délivré au premier contrôleur (11) ; et,
un signal (S1B_B) de détection d'un courant de fuite éventuel dans le second transistor (MT_1B) du second élément de commutation (20), délivré au second contrôleur (21) ; et, enfin,
- le second sous-circuit (320,321,322,D2) du second circuit de détection de courants de fuite (32) du module détecteur de courants de fuite (30) est adapté pour générer :
un signal (S2B_A) de détection d'un courant de fuite éventuel dans le second transistor (MT_2B) du second élément de commutation (20), délivré au premier contrôleur (11) ; et,
le signal (S2B_B) de détection d'un courant de fuite éventuel dans le second transistor (MT_2B) du second élément de commutation (20), délivré au second contrôleur (21).

9. Système électrique ou électronique embarqué dans un véhicule automobile, adapté pour être alimenté électriquement par une source d'alimentation électrique, et comprenant un circuit d'inhibition (1) par coupure d'alimentation électrique selon l'une quelconque des revendications 5 à 8.

10. Véhicule automobile comprenant une source d'alimentation électrique, un système électrique ou électronique alimenté électriquement par ladite source d'alimentation électrique, et un circuit d'inhibition (1) selon l'une quelconque des revendications 5 à 8 agencé entre ladite source d'alimentation électrique et ledit système, pour protéger ledit système par coupure d'alimentation électrique.

## Patentansprüche

1. Schaltung (31), die dazu bestimmt ist, einen Leckstrom in einer Sperrschaltung (1) zu erkennen, die durch Unterbrechen der elektrischen Energieversorgung eines elektrischen oder elektronischen Systems eines Kraftfahrzeugs arbeitet und die mindestens ein erstes Schaltelement (10) umfasst, das dazu geeignet ist in einen Ein-Zustand oder in einen Aus-Zustand versetzt werden kann, wobei das Schaltelement einen ersten Anschluss (100) und einen zweiten Anschluss (200) sowie einen ersten MOSFET-Transistor (MT_1A) und einen zweiten MOSFET-Transistor (MT_12) aufweist, die jeweils gekoppelt sind durch ihren Drain mit dem ersten Anschluss bzw. mit dem zweiten Anschluss verbunden und die in Reihe und Kopf an Schwanz geschaltet sind, um jeweils den Durchgang von Strom in einer der beiden möglichen Richtungen des Stromflusses durch das Schaltelement zu verhindern, wenn das Schaltelement eingeschaltet ist sich im ausgeschalteten Zustand befindet, wobei die Leckstromerkennungsschaltung **dadurch gekennzeichnet ist, dass** sie umfasst:
- einen ersten Eingangsanschluss (314) und einen zweiten Eingangsanschluss (315), die dazu bestimmt sind, mit dem ersten Anschluss (100) bzw. dem zweiten Anschluss (200) des Schaltelements (10) der Sperrschaltung gekoppelt zu werden ( 1);
- eine erste Teilschaltung (310,311,312,D1), die mit dem ersten Eingangsanschluss und dem zweiten Eingangsanschluss gekoppelt ist und dazu ausgelegt ist, jeden Leckstrom im ersten MOSFET-Transistor (MT_1A) des Schalters (10) der Sperrschaltung zu erkennen ( 1) wenn das Schaltelement so gesteuert wird, dass es sich im Aus-Zustand befindet; Und,
- eine zweite Teilschaltung (320,321,322,D2), die mit dem ersten Eingangsanschluss und dem zweiten Eingangsanschluss gekoppelt ist und dazu geeignet ist, jeden Leckstrom im zweiten MOSFET-Transistor (MT_2A) des Schalters (10) der Sperrschaltung zu erkennen ( 1) wenn das Schaltelement so gesteuert wird, dass es sich im Aus-Zustand befindet,
wobei der erste Teilschaltkreis und der zweite Teilschaltkreis getrennt und unabhängig voneinander sind.

2. Leckstromerkennungsschaltung nach Anspruch 1, bei der die erste Teilschaltung (310,311,312,D1) und die zweite Teilschaltung (320,321,322,D2) jeweils umfassen:
- einen Spannungskomparator (310,320) mit einem ersten Eingang, der eine bestimmte Schwellenspannung (Vth_1, Vth_2) empfängt, einem zweiten Eingang und einem Ausgang;
- eine isolierte Spannungsquelle (311,321), die so ausgelegt ist, dass sie eine bestimmte Referenzspannung (Vref_1, Vref_2) erzeugt, wenn sie durch ein Steuersignal (CRTL_PS_1A, CTRL_PS_2A) aktiviert wird; Und,
- eine Spannungsteilerbrücke (312,322), deren erster Eingang mit der Spannungsquelle gekoppelt ist, um die Referenzspannung zu empfangen, und deren zweiter Eingang mit dem zweiten Eingangsanschluss (315,325) bzw. dem ersten Eingangsanschluss (314,324) gekoppelt ist Leckstromerkennungsschaltung (31) und mit einem Ausgang (313,323), der mit dem zweiten Eingang des Komparators gekoppelt ist;
- eine Diode (D1, D2), die den Ausgang (313,323) der Spannungsteilerbrücke zum Kopieren mit dem ersten Eingang (314,324) bzw. dem zweiten Eingang (315,325) der Leckstromerkennungsschaltung (31) koppelt wobei der Ausgang die Spannung am Drain des ersten MOSFET-Transistors (MT_1A) bzw. die Spannung am Drain des zweiten MOSFET-Transistors (MT_2A) des Schaltelements (10) der Sperrschaltung (1) ausgibt,
wobei der Ausgang des Komparators dazu ausgelegt ist, mindestens ein Erkennungssignal (S1A_A, S2A_A) eines möglichen Leckstroms im ersten MOSFET-Transistor (MT_1A) bzw. im zweiten MOSFET-Transistor (MT_2A) des Schaltelements zu liefern ( 10) der Sperrschaltung (1), wenn die isolierte Spannungsquelle (311,321) durch das Steuersignal (CRTL_PS_1A, CTRL_PS_2A) aktiviert wird, während das Schaltelement (10) so gesteuert wird, dass es sich im Nicht-Durchgangszustand befindet.

3. Leckstromerkennungsschaltung nach Anspruch 2, bei der die erste Teilschaltung und die zweite Teilschaltung jeweils mindestens einen Optokoppler umfassen, der am Ausgang des Komparators (310,320) angeordnet ist, um das Erkennungssignal (S1A_A, S2A_A) zu liefern..

4. Leckstromerkennungsschaltung nach einem der Ansprüche 2 und 3, wobei die Spannungsteilerbrücke (312) der ersten Teilschaltung und/oder die Spannungsteilerbrücke (322) der zweiten Teilschaltung jeweils eine erste umfassen Widerstand (R11), der zwischen den ersten Eingang und den Ausgang (313,323) der Spannungsteilerbrücke geschaltet ist, sowie einen zweiten Widerstand (R12), der über eine Diode (D11, D12) zwischen den Ausgang (313,323) der Spannung geschaltet ist Teilerbrücke und dem zweiten Eingangsanschluss (315,325) bzw. dem ersten Eingangsanschluss (314,324) der Leckstromerkennungsschaltung (31).

5. Schaltung (1) zum Sperren durch Unterbrechen der elektrischen Energieversorgung eines elektrischen oder elektronischen Systems eines Kraftfahrzeugs, das von einer elektrischen Energiequelle elektrisch angetrieben wird, wobei die Sperrschaltung umfasst:
- einen ersten Anschluss (100), der zur Verbindung mit der elektrischen Stromquelle bestimmt ist, und einen zweiten Anschluss (200), der zur Verbindung mit dem System bestimmt ist;
- mindestens ein erstes Schaltelement (10) mit MOSFET-Transistoren, das zwischen dem ersten Anschluss und dem zweiten Anschluss der Schaltung angeordnet ist und in einen Ein-Zustand oder in einen Aus-Zustand versetzt werden kann, wobei das erste Schaltelement einen ersten umfasst Ein MOSFET-Transistor (MT_A1) und ein zweiter MOSFET-Transistor (MT_A2), die Kopf-an-Schwanz in Reihe zwischen dem ersten Anschluss (100) und dem zweiten Anschluss (200) angeordnet sind;
- eine erste Steuerung (11), die dazu ausgelegt ist, den Ein- oder Ausschaltzustand des ersten Schaltelements zu steuern; Und,
- ein Leckstrom-Detektormodul (30), das zwischen dem ersten Anschluss (100) und dem zweiten Anschluss (200) angeordnet ist und eine erste Leckstrom-Detektionsschaltung (31) nach einem der Ansprüche 1 bis 4 umfasst, die mit ihrer ersten gekoppelt ist Eingangsanschluss (314) und mit seinem zweiten Eingangsanschluss (315) zwischen dem ersten Anschluss (100) und dem zweiten Anschluss (200) der Hemmschaltung (1) parallel zum ersten Schaltelement (10), zur Erkennung eines möglichen Leckstrom im ersten MOSFET-Transistor (MT_1A) und/oder im zweiten MOSFET-Transistor (MT_2A) des ersten Schaltelements (10) der Sperrschaltung (1), wenn das erste Schaltelement (10) so gesteuert wird, dass es ausgeschaltet ist Zustand.

6. Inhibitionsschaltung nach Anspruch 5, weiterhin umfassend:
- ein zweites Schaltelement (20) mit MOSFET-Transistoren, wobei das erste Schaltelement (10) und das zweite Schaltelement (20) in Reihe Kopf-an-Schwanz zwischen dem ersten Anschluss und dem zweiten Anschluss angeordnet sind, wobei das zweite Schaltelement dient Das Element kann in einen Ein-Zustand oder in einen Aus-Zustand versetzt werden und umfasst einen ersten MOSFET-Transistor (MT_1B) und einen zweiten MOSFET-Transistor (MT_2B), die Kopf-an-Schwanz in Reihe zwischen dem ersten Anschluss (100) angeordnet sind, und der zweite Anschluss (200);
- einen zweiten Controller (21), der vom ersten Controller (11) elektrisch unabhängig ist und dazu geeignet ist, den Ein- oder Ausschaltzustand des zweiten Schaltelements (20) zu steuern,
wobei das Leckstrom-Detektormodul (30) eine zweite Leckstrom-Detektionsschaltung (32) nach einem der Ansprüche 1 bis 4 umfasst, die an ihrem ersten Eingangsanschluss (324) und an ihrem zweiten Eingangsanschluss (325) zwischen dem ersten gekoppelt ist Anschluss (100) und den zweiten Anschluss (200) der Sperrschaltung (1) parallel zum zweiten Schaltelement (20) zur Erkennung eines möglichen Leckstroms im ersten MOSFET-Transistor (MT_1B) und/oder im zweiten MOSFET Transistor (MT_2B) des zweiten Schaltelements (20) der Sperrschaltung (1), wenn das zweite Schaltelement (10) so gesteuert wird, dass es sich im Nicht-Durchgangszustand befindet.

7. Sperrschaltung nach Anspruch 5 oder Anspruch 6, bei der der erste Controller (11) und/oder der zweite Controller (21) jeweils eine Steuerlogik (12,22) und eine isolierte Gate-Steuerschaltung (13,23) umfassen ), angeordnet zwischen der Steuerlogik einerseits und den Steuergates des ersten und zweiten MOSFET-Transistors des ersten Schaltelements bzw. des zweiten Schaltelements andererseits.

8. Hemmschaltung nach einem der Ansprüche 6 und 7, wobei:
- der erste Teilschaltkreis (310,311,312,01) des ersten Leckstrom-Detektionsschaltkreises (31) des Leckstrom-Detektormoduls (30) ist dazu ausgelegt, Folgendes zu erzeugen:
ein Signal (S1A_A) zum Erkennen eines möglichen Leckstroms im ersten Transistor (MT_1A) des ersten Schaltelements (10), geliefert an den ersten Controller (11); Und,
ein Signal (S1A_B) zum Erkennen eines möglichen Leckstroms im ersten Transistor (MT_1A) des ersten Schaltelements (10), geliefert an den zweiten Controller (21);
- der zweite Teilschaltkreis (320,321,322,D2) des ersten Leckstrom-Detektionsschaltkreises (31) des Leckstrom-Detektormoduls (30) ist dazu ausgelegt, Folgendes zu erzeugen:
ein Signal (S2A_A) zum Erkennen eines möglichen Leckstroms im zweiten Transistor (MT_2A) des ersten Schaltelements (10), geliefert an den ersten Controller (11); Und,
ein Signal (S2A_A) zum Erkennen eines möglichen Leckstroms im zweiten Transistor (MT_2A) des ersten Schaltelements (10), geliefert an den zweiten Controller (21);
- der erste Teilschaltkreis (310,311,312,01) des zweiten Leckstrom-Detektionsschaltkreises (32) des Leckstrom-Detektormoduls (30) ist dazu ausgelegt, Folgendes zu erzeugen:
ein Signal (S1B_A) zum Erkennen eines möglichen Leckstroms im ersten Transistor (MT_1B) des zweiten Schaltelements (20), geliefert an den ersten Controller (11); Und,
ein Signal (S1B_B) zum Erkennen eines möglichen Leckstroms im zweiten Transistor (MT_1B) des zweiten Schaltelements (20), geliefert an den zweiten Controller (21); und schlussendlich,
- der zweite Teilschaltkreis (320,321,322,D2) des zweiten Leckstrom-Detektionsschaltkreises (32) des Leckstrom-Detektormoduls (30) ist dazu ausgelegt, Folgendes zu erzeugen:
ein Signal (S2B_A) zum Erkennen eines möglichen Leckstroms im zweiten Transistor (MT_2B) des zweiten Schaltelements (20), geliefert an den ersten Controller (11); Und,
das Signal (S2B_B) zur Erkennung eines möglichen Leckstroms im zweiten Transistor (MT_2B) des zweiten Schaltelements (20), an den zweiten Controller (21) geliefert.

9. Elektrisches oder elektronisches System an Bord eines Kraftfahrzeugs, das von einer elektrischen Energiequelle mit Strom versorgt werden kann und eine Sperrschaltung (1) zum Unterbrechen der elektrischen Energieversorgung nach einem der Ansprüche 5 bis 8 aufweist.

10. Kraftfahrzeug, umfassend eine elektrische Energiequelle, ein elektrisches oder elektronisches System, das von der elektrischen Energiequelle elektrisch gespeist wird, und eine Sperrschaltung (1) nach einem der Ansprüche 5 bis 8, die zwischen der Energiequelle und dem System angeordnet ist Schützen Sie das System vor einem Stromausfall.

## Claims

1. Circuit (31) intended to detect a leakage current in an inhibition circuit (1) which operates by cutting off the electrical power supply of an electrical or electronic system of a motor vehicle and which comprises at least a first switching element (10 ) adapted to be placed in an on state or in an off state, said switching element having a first terminal (100) and a second terminal (200) and having a first MOSFET transistor (MT_1A) and a second MOSFET transistor ( MT_12) which are each coupled by their drain to the first terminal and to the second terminal, respectively, and which are connected in series and head to tail to each prevent the passage of current in one of the two possible directions of current flow through the switching element when said switching element is in the off state, said leakage current detection circuit being **characterized in that** it comprises:
- a first input terminal (314) and a second input terminal (315) intended to be coupled to the first terminal (100) and to the second terminal (200), respectively, of the switching element (10 ) of the inhibition circuit (1);
- a first sub-circuit (310,311,312,D1) coupled to the first input terminal and to the second input terminal, and adapted to detect any leakage current in the first MOSFET transistor (MT_1A) of the switching (10) of the inhibition circuit (1) when said switching element is controlled to be in the off state; And,
- a second sub-circuit (320,321,322,D2) coupled to the first input terminal and to the second input terminal, and adapted to detect any leakage current in the second MOSFET transistor (MT_2A) of the switching (10) of the inhibition circuit (1) when said switching element is controlled to be in the off state,
wherein the first sub-circuit and the second sub-circuit are separate and independent of each other.

2. Leakage current detection circuit according to claim 1, in which the first sub-circuit (310,311,312,D1) and the second sub-circuit (320,321,322,D2) each comprise:
- a voltage comparator (310,320) having a first input receiving a determined threshold voltage (Vth_1, Vth_2), a second input, and an output;
- an isolated voltage source (311,321) adapted to generate a determined reference voltage (Vref_1, Vref_2) when it is activated by a control signal (CRTL_PS_1A, CTRL_PS_2A); And,
- a voltage divider bridge (312,322) with a first input coupled to the voltage source to receive the reference voltage, with a second input coupled to the second input terminal (315,325) or to the first input terminal ( 314,324), respectively, of the leakage current detection circuit (31), and with an output (313,323) coupled to the second input of the comparator;
- a diode (D1, D2) coupling the output (313,323) of the voltage divider bridge to the first input (314,324) or to the second input (315,325), respectively, of the leakage current detection circuit (31), for copying onto said output the voltage on the drain of the first MOSFET transistor (MT_1A) or the voltage on the drain of the second MOSFET transistor (MT_2A), respectively, of the switching element (10) of the inhibition circuit (1),
wherein the output of the comparator is adapted to deliver at least one detection signal (S1A_A, S2A_A) of a possible leakage current in the first MOSFET transistor (MT_1A) or in the second MOSFET transistor (MT_2A), respectively, of the switching element (10) of the inhibition circuit (1), when the isolated voltage source (311,321) is activated by the control signal (CRTL_PS_1A, CTRL_PS_2A) while the switching element (10) is controlled to be in the non-passing state.

3. Leakage current detection circuit according to claim 2, in which the first sub-circuit and the second sub-circuit each comprise at least one optocoupler arranged at the output of the comparator (310,320) to deliver the detection signal (S1A_A, S2A_A).

4. Leakage current detection circuit according to any one of claims 2 and 3, wherein the voltage divider bridge (312) of the first sub-circuit and / or the voltage divider bridge (322) of the second sub-circuit each comprise a first resistor (R11) connected between the first input and the output (313,323) of said voltage divider bridge, as well as a second resistor (R12) connected, through a diode (D11, D12), between the output (313,323) of said voltage divider bridge and the second input terminal (315,325) or the first input terminal (314,324), respectively, of the leakage current detection circuit (31).

5. Circuit (1) for inhibition by cutting off the electrical power supply of an electrical or electronic system of a motor vehicle electrically powered by an electrical power source, said inhibition circuit comprising:
- a first terminal (100) intended to be coupled to the electrical power source and a second terminal (200) intended to be coupled to the system;
- at least one first switching element (10) with MOSFET transistors arranged between the first terminal and the second terminal of the circuit and adapted to be able to be placed in an on state or in an off state, said first switching element comprising a first MOSFET transistor (MT_A1) and a second MOSFET transistor (MT_A2) arranged in series, head to tail, between the first terminal (100) and the second terminal (200);
- a first controller (11) adapted to control the on or off state of the first switching element; And,
- a leakage current detector module (30) arranged between the first terminal (100) and the second terminal (200), and comprising a first leakage current detection circuit (31) according to any one of claims 1 to 4, coupled by its first input terminal (314) and by its second input terminal (315) between the first terminal (100) and the second terminal (200) of the inhibition circuit (1) in parallel with the first switching element (10), for detecting a possible leakage current in the first MOSFET transistor (MT_1A) and/or in the second MOSFET transistor (MT_2A) said first switching element (10) of the inhibition circuit (1) when said first switching element (10) is controlled to be in the off state.

6. Inhibition circuit according to claim 5, further comprising:
- a second switching element (20) with MOSFET transistors, the first switching element (10) and the said second switching element (20) being arranged in series, head to tail, between the first terminal and the second terminal, the said second switching element being adapted to be able to be placed in an on state or in an off state and comprising a first MOSFET transistor (MT_1B) and a second MOSFET transistor (MT_2B) arranged in series, head to tail, between the first terminal (100) and the second terminal (200);
- a second controller (21) electrically independent of the first controller (11) and suitable for controlling the on or off state of the second switching element (20),
wherein the leakage current detector module (30) comprises a second leakage current detection circuit (32) according to any one of claims 1 to 4, coupled at its first input terminal (324) and at its second input terminal (325) between the first terminal (100) and the second terminal (200) of the inhibition circuit (1) in parallel with the second switching element (20), for detecting a possible leakage current in the first MOSFET transistor (MT_1B) and/or in the second MOSFET transistor (MT_2B) of the second switching element (20) of the inhibition circuit (1) when said second switching element (10) is controlled to be in the non-passing state.

7. Inhibit circuit according to Claim 5 or Claim 6, in which the first controller (11) and/or the second controller (21) each comprise a control logic (12,22) and a gate control circuit. isolated (13,23) arranged between said control logic, on the one hand, and the control gates of the first and second MOSFET transistors of the first switching element and of the second switching element, respectively, on the other hand.

8. Inhibition circuit according to any one of claims 6 and 7, wherein:
- the first sub-circuit (310,311,312,D1) of the first leakage current detection circuit (31) of the leakage current detector module (30) is adapted to generate:
a signal (S1A_A) for detecting a possible leakage current in the first transistor (MT_1A) of the first switching element (10), delivered to the first controller (11); And,
a signal (S1A_B) for detecting a possible leakage current in the first transistor (MT_1A) of the first switching element (10), delivered to the second controller (21);
- the second sub-circuit (320,321,322,D2) of the first leakage current detection circuit (31) of the leakage current detector module (30) is adapted to generate:
a signal (S2A_A) for detecting a possible leakage current in the second transistor (MT_2A) of the first switching element (10), delivered to the first controller (11); And,
a signal (S2A_A) for detecting a possible leakage current in the second transistor (MT_2A) of the first switching element (10), delivered to the second controller (21);
- the first sub-circuit (310,311,312,D1) of the second leakage current detection circuit (32) of the leakage current detector module (30) is adapted to generate:
a signal (S1B_A) for detecting a possible leakage current in the first transistor (MT_1B) of the second switching element (20), delivered to the first controller (11); And,
a signal (S1B_B) for detecting a possible leakage current in the second transistor (MT_1B) of the second switching element (20), delivered to the second controller (21); and finally,
- the second sub-circuit (320,321,322,D2) of the second leakage current detection circuit (32) of the leakage current detector module (30) is adapted to generate:
a signal (S2B_A) for detecting a possible leakage current in the second transistor (MT_2B) of the second switching element (20), delivered to the first controller (11); And,
the signal (S2B_B) for detecting a possible leakage current in the second transistor (MT_2B) of the second switching element (20), delivered to the second controller (21).

9. Electrical or electronic system on board a motor vehicle, adapted to be electrically powered by an electrical power source, and comprising an inhibition circuit (1) by cutting off the electrical power supply according to any one of claims 5 to 8.

10. Motor vehicle comprising an electrical power source, an electrical or electronic system electrically powered by said electrical power source, and an inhibition circuit (1) according to any one of claims 5 to 8 arranged between said source power supply and said system, to protect said system by power failure.
